# EUROPÄISCHE PATENTSCHRIFT

(11) **EP 1 014 034 B1**
(45) Veröffentlichungstag und Bekanntmachung des Hinweises auf die Patenterteilung: **18.06.2008**
(21) Anmeldenummer: 99124602.6
(22) Anmeldetag: 10.12.1999
(51) Int. Cl.: G01B 11/02, G01D 5/38

(54) **Integrierter optoelektronischer Sensor und Verfahren zu dessen Herstellung**
Integrated optoelectronic sensor and method for its production
Capteur optoélectronique integré et procédé pour sa production

(30) Priorität: 23.12.1998 DE 19859669
(43) Veröffentlichungstag der Anmeldung: 28.06.2000
(73) Patentinhaber: Dr. Johannes Heidenhain GmbH, 83292 Traunreut (DE)
(72) Erfinder: Speckbacher, Peter, 84558 Kirchweidach (DE); Michel, Dieter, 83278 Traunstein (DE)

(56) Entgegenhaltungen:
- DE-A- 19 701 941
- DE-C- 19 524 725
- US-A- 5 666 196
- US-A- 5 670 781

## Beschreibung

Die Erfindung betrifft einen integrierten optoelektronischen Sensor für ein Messsystem nach Anspruch 1 und ein Verfahren zu dessen Herstellung gemäss Anspruch 25.

Aus der GB 1,504,691 und der korrespondierenden DE 25 11 350 A1 ist ein Messsystem bekannt, bei dem die Verschiebung einer ersten Baugruppe relativ zu einer zweiten Baugruppe ermittelt wird. Dafür sind zwei Gitter vorgesehen, die zueinander einen konstanten Abstand aufweisen und von denen je eines an einer Baugruppe befestigt wird. Wird das zweite Gitter mit divergentem Licht einer Lichtquelle bestrahlt, erzeugt das erste Gitter ein periodisches Abbild des zweiten Gitters, wobei sich dieses Abbild bewegt, wenn zwischen den beiden Baugruppen eine relative Bewegung vorliegt. Weiterhin sind Fotodetektoren vorgesehen, die eine periodische Struktur aufweisen und fest mit der zweiten Baugruppe verbunden sind. Dabei ist das erste ein reflektierendes Gitter und das zweite Gitter und die Fotodetektoren liegen im wesentlichen in einer Ebene. Die Lichtquelle und das zweite Gitter können auch durch eine strukturierte Lichtquelle ersetzt werden, die das gleiche Abbild wie eine herkömmliche Lichtquelle und ein Gitter erzeugen.

Die Struktur der Fotodetektoren interagiert mit dem Abbild derart, dass eine periodische Änderung des Ausgabesignals der Fotodetektoren auftritt, wenn zwischen erster und zweiter Baugruppe eine Relativbewegung vorliegt.

Dabei ist von Nachteil, dass die einzelnen Baugruppen diskret und separat realisiert werden. Dadurch ist ein relativ grosser Einbauraum für die gesamte Anordnung erforderlich.

Aus der DE 197 01 941 A1 ist bekannt, dass auf der einem Massstab zugewandten Seite eines lichtdurchlässigen Trägers ein Abtastgitter angeordnet ist. Das Abtastgitter wird von einer Lichtquelle derart bestrahlt, dass ein Abbild des Gitters auf den Massstab projeziert wird. Auf dem Massstab befindet sich ein zweites Gitter, welches das Abbild auf einen strukturierten Fotodetektor reflektiert. Dabei sind der lichtdurchlässige Träger für das erste Gitter mit dem Halbleitermaterial, in dem der strukturierte Fotodetektor realisiert ist, miteinander derart verbunden, dass Abtastgitter und Fotodetektor ausschliesslich in Messrichtung zueinander versetzt sind, vom Massstab aber die gleiche Entfernung aufweisen. In einer zweiten Ausführungsform der DE 197 01 941 A1 ist das Abtastgitter auf der dem Massstab abgewandten Seite des lichtdurchlässigen Trägers angeordnet. Auf der gleichen Seite wie das Abtastgitter ist ein Optochip auf dem gleichen lichtdurchlässigen Träger angeordnet, welches den Fotodetektor beinhaltet. Auch durch diese Anordnungen wird erreicht, dass Abtastgitter und strukturierter Fotodetektor ungefähr den gleichen Abstand vom Massstab aufweisen.

Bei der ersten Ausführungsform besteht der Nachteil, dass der lichtdurchlässige Träger, auf dem das Abtastgitter aufgebracht ist, mit dem Halbleitermaterial, in dem der strukturierte Fotodetektor realisiert ist, verbunden werden muss. Diese Verbindung muss sehr genau erfolgen, so dass die Struktur des Fotodetektors parallel zum Gitter ausgerichtet ist und Struktur und Gitter den gleichen Abstand vom Massstab aufweisen. Diese exakte Verbindung zwischen Träger und Halbleitermaterial ist daher sehr schwierig zu realisieren. Weiterhin weist die zweite Ausführungsform den Nachteil auf, dass ein Optochip auf dem lichtdurchlässigen Träger befestigt werden muss.

Durch die Befestigung in Chip-on-Glass Technologie entsteht zwangsläufig ein Abstand zwischen dem Optochip und dem Träger, wodurch der Abstand zwischen Abtastgitter und Massstab sowie zwischen Fotodetektor und Massstab wesentlich voneinander abweichen, was zu einer deutlichen Verschlechterung der optischen Eigenschaften der Anordnung führt.

Aus der DE 40 91 517 C2 ist bekannt, einen Sensor für ein Messsystem aus einem einzigen Block aus Halbleitermaterial zu realisieren. Dabei sind auf der Oberfläche einer flächig ausgestalteten Leuchtdiode als Gitterlinien ausgestaltete Fotoelemente vorgesehen, durch welche die Leuchtdiode nicht hindurchstrahlen kann. Dadurch entsteht ein strukturierter Fotodetektor, über bzw. unter dem eine strukturierte Lichtquelle angeordnet ist.

Dieser Sensor weist den Nachteil auf, dass die Fotodetektorstruktur und die strukturierte Lichtquelle zwangsläufig nicht den gleichen Abstand zu einem Massstab aufweisen können, da Leuchtdiode und Fotodetektor übereinander realisiert werden. Dieser unterschiedliche Abstand zum Massstab verschlechtert wiederum die optischen Eigenschaften des Sensors deutlich.

Aus der EP 543 513 A1 ist bekannt, dass auf einem gemeinsamen Halbleitersubstrat aus III/V-Halbleitermaterial, wie beispielsweise Gallium-Arsenid GaAs, sowohl ein strukturierter Fotodetektor als auch eine strukturierte Lichtquelle in Form von mindestens einer Leuchtdiode eines Sensors realisiert werden. Durch diese Realisierung der strukturierten Lichtquelle und des strukturierten Fotodetektors auf einem gemeinsamen Halbleitermaterial kann die Forderung, dass die Sende- und Empfangsstrukturierung möglichst in einer Ebene zu realisieren ist, sehr gut erfüllt werden. Weiterhin erfolgt eine Einfeldabtastung, bei der die Fotoelemente um 90° + k* 360°, mit ganzzahligem k, versetzt sind. Es werden also mehrere Fotoelemente um neunzig Winkelgrad plus ganzzahlige Vielfache von dreihundertsechzig Winkelgrad in Messrichtung zueinander versetzt angeordnet. Dadurch wird die Abtastung besonders störunempfindlich.

Dabei ist von Nachteil, dass nicht beschrieben wird, wie die Herstellung des strukturierten Fotodetektors und der strukturierten Lichtquelle auf einem gemeinsamen Halbleitermaterial aus GaAs erfolgt. Werden aus dem Stand der Technik bekannte Technologien der Halbleiterherstellung angewandt, so ist dieser Herstellungsprozess sehr aufwendig und damit teuer.

Aus der EP 720 005 A2 ist ein optischer Sensor für ein Messsystem bekannt, der ein Licht emittierendes Bauteil, ein Licht empfangendes Bauteil, und mindestens ein optisches Bauteil aufweist, das auf das vom Licht emittierenden Bauteil gesendeten Lichtstrahl einwirkt, bevor dieser das Licht empfangende Bauteil erreicht. Dieser Sensor weist ein Abstandselement auf, welches einen Abstand zwischen dem Licht emittierenden bzw. dem Licht empfangenden Bauteil und dem optischen Bauteil definiert. Dabei ist das Abstandselement derart ausgestaltet, dass es mit einem anderen Bauteil verbunden wird. Dadurch wird erreicht, dass der optisch Sensor auf seiner einen Seite optische Signale sendet und empfängt, weshalb optische Bauteile auf dieser Seite angeordnet werden, und auf seiner anderen Seite Leitungen für elektrische Signale aufweist.

Dabei ist von Nachteil, dass das Licht empfangende Bauteil, das Licht emittierende Bauteil, das mindestens eine optische Bauteil und das Abstandselement alle aus separaten Bauteilen bestehen, die separat gefertigt und zusammengebaut werden müssen. Dies ist bei den geforderten Genauigkeiten für optische Sensoren von Messsystemen sehr teuer. Weiterhin ist der optische Sensor relativ voluminös, da die einzelnen Bauteile auch separat gehandhabt werden müssen.

Aus der DE 197 20 300 A1 ist ein elektronisches Hybridbauelement bekannt, bei dem in Chip on Chip Anordnung ein implantiertes Chip auf einem Trägersubstrat angeordnet wird. Dafür weist das Trägersubstrat mindestens eine Kavität auf, in der sich eine elektrische Isolationsschicht mit einer darüber liegenden Metallschicht befindet. Der in die Kavität implantierte Chip wird mit der Metallschicht kontaktiert, wodurch diese als elektrische Leitung verwendet wird. Ist der implantierte Chip eine Leuchtdiode, kann die Metallisierungsschicht auch dazu benutzt werden, deren Strahlung an den Wänden der Kavität zu reflektieren.

Diese Anordnung weist den Nachteil auf, dass sowohl die Strahlungsrichtung der Leuchtdiode als auch deren elektrischen Kontakte auf einer Seite des Halbleitersubstrats angeordnet sind bzw. auf dieser einen seite emittiert werden.

Aus der DE 196 18 593 A1 ist ein strahlungsempfindliches Detektorelement mit einem aktiven Bereich bekannt, wobei sich der aktive Bereich zwischen zwei aneinandergrenzenden Schichtbereichen einer Schichtanordnung mit unterschiedlichen Ladungsträgern ausbildet und innerhalb dessen eine Umwandlung einfallender elektromagnetischer Strahlung in elektrische Signale erfolgt. Dabei ist die Lage des aktiven Bereichs relativ zu den beiden begrenzenden Oberflächen unter Berücksichtigung der Eindringtiefe der Strahlung derart gewählt, dass mindestens zwei Kontaktelemente zum Anschluss des Detektorelements an eine Auswerteschaltung an einer Oberfläche montierbar sind, die gegenüber der strahlungsempfindlichen Oberfläche liegt, auf die die einfallende Strahlung auftrifft. Bei dem Herstellungsverfahren eines solchen Detektorelements werden die folgenden Verfahrensschritte angewendet. Es wird eine Ätzstopschicht in einem definiert dotierten Halbleitersubstrat knapp unterhalb einer begrenzenden ersten Oberfläche erzeugt. Dann folgt ein räumlich selektives Wegätzen des unterhalb der Ätzstopschicht vorhandenen Substrats, bis die Ätzstopschicht eine begrenzende zweite Oberfläche bildet. Anschliessend wird ein räumlich begrenzter Schichtbereich oberhalb der Ätzstopschicht, der eine unterschiedliche Dotierung als das Halbleitersubstrat aufweist, erzeugt und das Detektorelement wird auf einer Seite, die gegenüberliegend zur zweiten Oberfläche ist, mit mindestens zwei Kontaktelementen kontaktiert.

Dabei ist von Nachteil, dass hier lediglich eine Fotodiode offenbart ist, jedoch kein vollständiger optoelektronischer Sensor.

Die DE-A-195 24 725 beschreibt einen integrierten optoelektronischen Sensor zum Auslesen eines Massstabs, bei dem auf der einen Seite eines transparenten Substrats eine Lichtquelle, zwei Photodioden und eine Signalverarbeitungskomponente aufgebracht sind, während die andere Seite des transparenten Substrates ein Gitter trägt und dem Massstab zugewandt ist.

Es stellt sich daher die Aufgabe, einen integrierten optoelektronischen Sensor und ein Verfahren zu dessen Herstellung anzugeben, bei dem möglichst viele Bauelemente des Sensors in ein Halbleitersubstrat integriert ausgeführt werden und auf der einen Seite des Halbleitersubstrats alle elektrischen und auf der anderen Seite alle optischen Signale gesendet und empfangen werden. Dabei soll das Herstellungsverfahren für den integrierten optoelektronischen Sensor möglichst kostengünstig sein.

Diese Aufgabe wird durch eine Anordnung mit den Merkmalen des Anspruchs 1 und ein Verfahren mit den Merkmalen des Anspruchs 25 gelöst.

Vorteilhafte Ausführungsformen der erfindungsgemässen Anordnung und des erfindungsgemässen Verfahrens ergeben sich aus den Merkmalen der jeweils abhängigen Ansprüche.

Die erfindungsgemässe Anordnung weist den Vorteil auf, dass die Uchtquelle, die Fotoelemente und die Verstärker sowie die Interpolationseinheit auf einem Halbleitersubstrat integriert werden können. Ein weiterer Vorteil ist, dass alle elektrischen Kontakte der Bauteile des Sensors auf der von dem Massstab abgewandten Seite des Sensors angeordnet sind und die optischen Signale auf der dem Massstab zugewandten Seite des Sensors emittiert und empfangen werden. Weiterhin vorteilhaft sind die kleine Bauweise und der hohe Integrationsgrad, welche zu kostengünstigen Herstellungskosten führen. Weiterhin von Vorteil ist, dass der optoelektronische Chip mit Fotoelementen, Lichtquelle und Auswerteelektronik technologisch einfach mit dem Träger für das Abtastgitter verbunden werden kann.

Weitere vorteilhafte Ausgestaltungen sind den jeweils abhängigen Ansprüchen und der Beschreibung zu entnehmen.

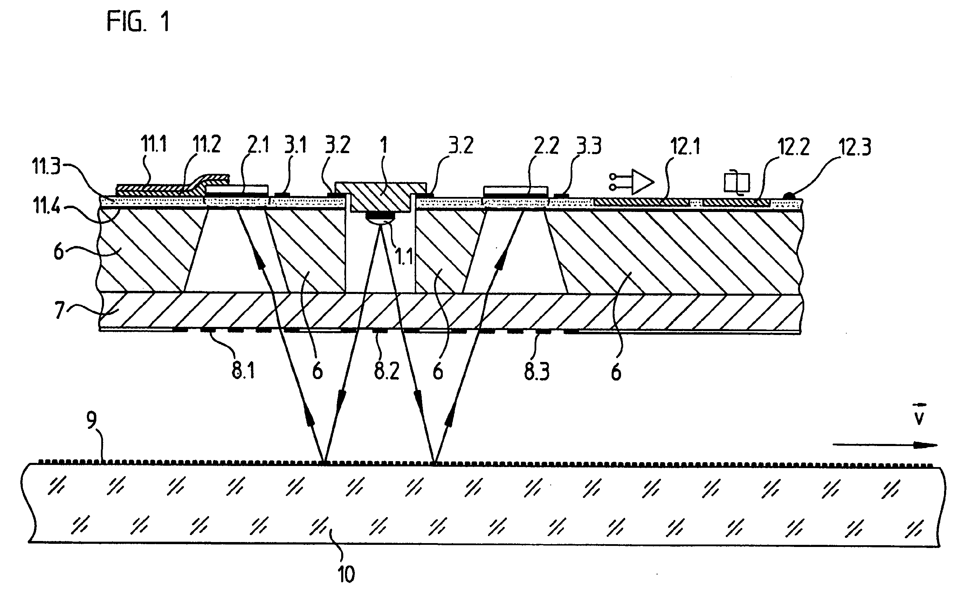

Einzelheiten der Erfindung werden im folgenden anhand der in der Zeichnung dargestellten Ausführungsform näher erläutert.

Die einzige Figur zeigt einen Schnitt durch den erfindungsgemässen Sensor mit Massstab.

Der erfindungsgemässe Sensor wird im folgenden anhand eines Ausführungsbeispiels erläutert, das ein Längenmesssystem beinhaltet. Es besteht jedoch die Möglichkeit, ohne wesentliche Änderungen, den erfindungsgemässen Sensor auch bei einem Winkelmesssystem oder einem zweidimensionalen Messsystem einzusetzen.

In der Figur ist der erfindungsgemässe optoelektronische Sensor schematisch dargestellt. Auf der vom Massstab 10 abgewandten Seite des Halbleitersubstrats 6 sind unter Passivierungsschichten 11.1 und 11.2, die aus Siliziumoxid und/oder Siliziumnitrit bestehen, Fotodioden 2.1 und 2.2 angeordnet. Deren Herstellung ist aus dem Stand der Technik gemäss DE 196 18 593 A1 bekannt und soll hier nicht näher erläutert werden. Die Fotodioden 2.1 und 2.2 werden unmittelbar in dem Halbleitersubstrat 6 gefertigt, das den erfindungsgemässen Sensor bildet. Die beiden Fotodioden 2.1 und 2.2 symbolisieren lediglich mindestens je eine funktionale Baugruppe, die mehrere Fotodioden oder auch mehrere miteinander verschaltete Gruppen von Fotodioden, beispielsweise für eine Einfeldabtastung, beinhalten können.

Diese funktionalen Baugruppen Fotodioden 2.1 und 2.2 sind symmetrisch zu einer Strahlenquelle 1 für elektromagnetische Strahlung, insbesondere Licht, angeordnet, die bevorzugt durch eine Leuchtdiode 1 realisiert wird. Dabei kann die Leuchtdiode 1 als separates Bauteil mit dem Halbleitersubstrat 6 verbunden werden, wie in der Figur dargestellt. Alternativ kann auch aus dem Halbleitersubstrat 6, in dem die Fotodioden 2.1 und 2.2 realisiert sind, durch entsprechende Dotierung eine Leuchtdiode 1 hergestellt werden. Da letztere Alternative jedoch schwierig zu realisieren ist, wird gemäss der Figur für die Leuchtdiode 1 ein separates SMD-Bauteil bevorzugt. Damit die Strahlung der Leuchtdiode 1, die auf der gleichen Seite des Halbleitersubstrats 6 wie die Fotodioden 2.1 und 2.2 angeordnet ist, auf die andere Seite des Halbleitersubstrats 6 gelangen kann, wird das Halbleitersubstrat 6 an dieser Stelle mittels anisotroper Ätzung vollständig durchgeätzt. Die Leuchtdiode kann ein optisches Bauteil, wie beispielsweise eine Linse 1.1 aufweisen, die deren Strahlung in Richtung der anderen Seite des Halbleitersubstrats 6 kollimiert.

Weiterhin sind auf der vom Massstab 10 abgewandten Seite des Halbleitersubstrats 6 weitere elektrische Baugruppen angeordnet. Neben elektrischen Leitungen 3.1 sowie 3.3 und Kontaktflächen 3.2 sowie 12.3 sind auch komplexe Halbleiterschaltungen 12.1 und 12.2 auf diesem gemeinsamen Halbleitersubstrat 6 realisiert. Dabei handelt es sich bevorzugt um rauscharme Verstärker 12.1 für die Ausgangssignale der Fotodiodenbaugruppen 2.1 und 2.2 sowie um eine Interpolationsbaugruppe 12.2 für die Ausgangssignale der rauscharmen Verstärker 12.1.

Das Halbleitersubstrat 6 ist auf der dem Massstab 10 zugewandten Seite mit einem für die von der Leuchtdiode 1 emittierte Strahlung transparenten Träger 7 verbunden. Diese Verbindung kann durch thermisches oder anodisches Bonden erreicht werden. Dieser transparente Träger 7 weist eine oder mehrere Teilungen 8.1, 8.2 und 8.3 auf, deren genaue Struktur von dem zu realisierenden Messsystem abhängig ist. Diese Teilungen 8.1, 8.2 und 8.3 werden bevorzugt auf der dem Massstab zugewandten Seite des Trägers 7 aufgebracht, wie in der Figur gezeigt. Alternativ ist bei einer Anordnung der Teilungen8.1, 8.2 und 8.3 auf der anderen Seite des Trägers 7 darauf zu achten, dass die Teilungen 8.1, 8.2 und 8.3 nur die freien Flächen bedekken, an denen kein Halbleitersubstrat 6 vorhanden ist. Ansonsten ist nur eine mangelhafte Verbindung zwischen Halbleitersubstrat 6 und Träger 7 möglich.

Der derart aufgebaute optoelektronische Sensor wird gegenüber einem Massstab 10 angeordnet, der eine Teilung 9 trägt. Sendet die Leuchtdiode 1 einen durch eine Linse 1.1 kollimiertes Lichtbündel in Richtung Massstab 10, wird dieses Lichtbündel an der Teilung 8.2 erstmals gebeugt, trifft dann auf die Teilung 9 des Massstabs 10, wird dort gebeugt und an den Teilungen 8.1 und 8.3 erneut gebeugt, bevor er auf die Fotodioden 2.1 und 2.2 trifft, durch die die Intensität des Lichtstrahl erfasst wird. Das Ausgangssignal der Fotodioden 2.1 und 2.2 wird mindestens einem Verstärker 12.1 und dessen Ausgangssignal mindestens einem Interpolator 12.2 zugeleitet, wobei all diese Baugruppen auf dem Halbleitersubstrat realisiert sind.

Um die elektrische Verdrahtung in einer Ebene ausführen zu können, werden die Fotoelemente 2.1 und 2.2 als Membrane ausgeführt, wie in der Figur dargestellt. Hierzu wird insbesondere auf den Stand der Technik gemäss DE 196 18 593A1 verwiesen. Der Ätzprozess zur Herstellung der Membrane kann als Nass- oder Trockenätzprozess ausgeführt werden. Beim Nassätzprozess ist der Ätzwinkel durch die Kristallorientierung vorgegeben (ca. 54° bei 1-0-0 Siliziumkristall). Beim Nassätzsprozess ist ein definierter Ätzstop für die Membrandicke wichtig, dies wird erreicht durch ein sog. SIMOX Substrat, in dem ein vergrabenes SiO₂ als Ätzstop wirkt. Beim Ätzen mit Hilfe einer Plasmaentladung können Ätzwinkel bis 90° hergestellt werden. Verwendete Ätzgase hierfür sind Schwefelhexaflourid (SF₆), Triflourmethan (CHF₃) und Sauerstoff (O₂). Durch eine alternierende Zugabe der Ätzgase während dem Ätzprozess kann hierbei der Ätzwinkel eingestellt werden. Das Ätzgas Schwefelhexaflourid bewirkt einen vorwiegend anisotropen Ätzprozess, Triflourmethan einen vorwiegend isotropen Ätzprozess. Bevorzugte Plasmaätzer hierfür verwenden eine sogenannte inductive coupled plasma Quelle. Die Dicke der Membrane kann je nach Wellenlänge optimiert angepasst werden, z. B. 30 µm Membrandicke der Fotodioden 2.1 und 2.2 bei 860 nm Wellenlänge der von der Leuchtdiode 1 abgestrahlten elektromagnetischen Strahlung.

Um eine Generation von Ladungsträgern - beispielsweise durch Streulicht - ausserhalb der aktiven Membrane zu vermeiden, können die Seitenflächen der rückgeätzten Wände des Halbleitersubstrats 6 metallisch verspiegelt werden. Senkrechte aber auch nicht senkrechte Wände können mit einer metallischen Verspiegelung durch Sputtern von Metallen (z. B. Aluminium oder Chrom) belegt werden.

Alternativ können durch Streulicht erzeugte Ladungsträger ausserhalb der aktiven Membrane der Fotodioden 2.1 und 2.2 durch die Verwendung eines aus dem Stand der Technik bekannten SIMOX Substrates unterdrückt werden. Die Erzeugung von Ladungsträgern findet dann nur in der obersten Siliziumschicht 11.3 statt, welche elektrisch durch das SIMOX - Oxid vom Halbleitersubstrat 6 getrennt ist. Im Halbleitersubstrat 6 erzeugte Elektron-Lochpaare gelangen aufgrund der Oxidschicht 11.4 nicht zu den Fotodioden 2.1 und 2.2.

Um eine Erhöhung der Empfindlichkeit der Fotoelemente 2.1 und 2.2 zu erreichen, kann an der Oberfläche der aktiven Membrane, unter der Passivierungsschicht 11.2 ein Reflektor aufgebracht werden (z.B. Aluminium mit Sputtertechnik). Ist dieser Reflektor leitend, kann er auch als ein elektrischer Anschluss der Fotodioden benutzt werden. Durch den Reflektor werden sonst austretende Lichtstrahlen nochmals in den aktiven Bereich der Membrane der Fotodioden 2.1 und 2.2 reflektiert und erhöhen damit den Photostrom.

Zusätzlich kann die dem Lichteintritt zugewandten Seite des Photoelements, also die Unterseite der Membrane, durch zusätzliche Schichten aus SiO₂ und/oder Si₃N₄ entspiegelt werden. Die Schichtdicke dieser Entspiegelungsschicht wird dabei abhängig von der Wellenlänge der von der Leuchtdiode 1 ausgesendeten Strahlung gewählt. Dadurch erhöht sich ebenfalls die Empfindlichkeit der Fotodioden 2.1 und 2.2.

Die Lichtquelle, beispielsweise eine Leuchtdiode 1, wird auf derselben Ebene integriert und elektrisch kontaktiert wie die Fotodioden 2.1 und 2.2 und die Verstärker- 12.1 und Interpolationseinheit 12.2, wie in der Figur dargestellt. Hierzu wird in einem Ätzprozess eine vollständig durchgehende Öffnung in den Siliziumträger eingebracht. Die Leuchtdiode 1 wird von oben als SMD Element bestückt. Alternativ besteht auch die Möglichkeit einen Trägerkörper für die Leuchtdiode 1 vorzusehen, um die Abstrahlebene der Leuchtdiode 1 in der Höhe zu variieren.

Als Trägerkörper der Leuchtdiode 1 kann ein Gehäuse aus Silizium oder insbesondere Gallium-Arsenid GaAs benutzt werden. Dadurch wird sichergestellt, dass der Trägerkörper denselben Ausdehnungskoeffizienten aufweist wie die Leuchtdiode 1, die in der Regel aus GaAs realisiert ist. Bei Verwendung der genannten Materialien als Trägerkörper für die Leuchtdiode 1 ist auch gewährleistet, dass aufgrund der guten Wärmeleitfähigkeit des Trägerkörpers eine gute Wärmesenke für die Leuchtdiode 1 entsteht. Dies wirkt sich positiv bezüglich der Lebensdauer und Leistung der Leuchtdiode 1 aus. Der Trägerkörper dient gleichzeitig als elektrische Kontaktierung für die SMD Bestückung auf der Siliziumoberfläche und für die Kontaktierung der Leuchtdiode 1 selbst. Auf der abstrahlenden Oberfläche der Leuchtdiode 1 kann bereits eine Linse 1.1 aufgebracht sein um den Strahlengang zu beeinflussen. Die Rückseite des Trägerkörpers der Leuchtdiode 1 kann durch einen keramischen Schild gegen Wärmeeinstrahlung geschützt werden, ebenso kann dadurch Wärmeabstrahlung verhindert werden.

Dadurch dass alle elektrischen Anschlüsse für die Leuchtdiode 1, die Fotoelemente 2.1 und 2.2, die Verstärker- 12.1 und Interpolationseinheit 12.2 auf einer Ebene liegen, lassen sich die elektrischen Verbindungsleitungen 3.1, 3.3 zu Verarbeitungsbaugruppen für die Ausgangssignale der optoelektronischen Bauteile einfach ausführen. Ein weiterer Vorteil bei Verwendung des SIMOX Substrates ist, dass die elektrisch aktive Oberfläche bereits elektrisch isoliert ist vom Halbleitersubstrat 6. Zudem bildet die epitaktisch aufgewachsene Silizium-Schicht 11.3 aufgrund der Reinheit und der kristallinen Ordnung der Schicht ideale Voraussetzung um Verstärker- und Interpolationseinheit zu integrieren. Eine bevorzugte Technologie ist ein CMOS kompatibler Technologieprozess zur Integration von Verstärker 12.1 und Interpolationseinheit 12.2.

Die gesamte Oberfläche der Kontaktierungsebene kann mit einer Passivierungsschicht 11.1 und 11.2, beispielsweise aus SiO₂ und Si₃N₄ mittels CVD Prozess (Chemical vapour deposition) geschützt werden.

Bevorzugtes Material für das Halbleitersubstrat 6 ist Silizium mit einer Kristallorientierung (1-0-0), um beim Nassätzprozess einen bevorzugten Winkel von 54° zu erreichen. Zudem ist auch für eine CMOS Integration für die Verstärker- 12.1 und Interpolationseinheit 12.2 Silizium mit dieser Orientierung zu bevorzugen.

Der Träger 7, welcher auf der Unterseite des Halbleitersubstrats 6 aufgebracht wird, trägt die für die optische Wirkung notwendigen Gitterstrukturen 8.1, 8.2 und 8.3, wie in der Figur dargestellt. Die Gitterstrukturen 8.1, 8.2 und 8.3 können als Phasengitter und/oder als Amplitudengitter, z. B. als Chromgitter ausgeführt werden. Die Gitterstrukturen 8.1, 8.2 und 8.3 können auf der dem Halbleitersubstrat 6 abgewandten Seite aufgebracht sein. Möglich ist auch, dass die Gitterstrukturen 8.1, 8.2 und 8.3 auf der dem Halbleitersubstrat 6 zugewandten Seite des Trägers 7 aufgebracht werden. Wichtig ist hierbei, dass die Gitterstrukturen 8.1, 8.2 und 8.3 dann in die Öffnung unterhalb der Photoelemente 2.1 und 2.2 sowie der Leuchtdiode 1 nur örtlich eingebracht. Der Vorteil ist dann, dass die Verbindung von Halbleitersubstrat 6 und Glas durch die Abtastgitter 8.1, 8.2 und 8.3 nicht behindert wird.

In einer alternativen Ausgestaltung kann der Träger 7 sowohl auf seiner dem Massstab 10 abgewandten Seite als auch dem Massstab 10 zugewandten Seite jeweils mindestens ein Gitter aufweisen. Diese mindestens zwei auf beiden Seiten des Trägers 7 aufgebrachten Gitter können dabei sowohl als Phasengitter als auch als Amplitudengitter als auch als eine Kombination aus Phasen- und Amplitudengitter realisiert sein. Die Strukturierung des Phasengitters kann dabei nicht nur parallel zu den Gitterlinien der Teilung 9 auf dem Massstab 10 angeordnet sein, sondern auch senkrecht dazu gewählt werden. Durch eine derartige azimuthale Anordnung werden mehr Bereiche auf der Teilung 9 gleichzeitig abgetastete, wodurch die Verschmutzungsempfindlichkeit verringert wird.

Eine weitere Alternative ist die Einbringung einer optischen Linse in den Träger 7 unterhalb der Abstrahlungsebene der Leuchtdiode 1. Aufgrund der Siliziumöffnung kann die Linse im Träger 7 wieder auf der dem Massstab 10 zu- und abgewandten beiden Seiten des Trägers 7 aufgebracht werden. Technologisch wird eine solche Linse beispielsweise durch Elektronenlithografie in PMMA - Resist erreicht. Die Wölbung der Linse im Resist wird durch unterschiedliche Bestrahlungsdosen im Resist erreicht, die Resiststruktur wird dann durch Plasmaätzen in den Träger 7 übertragen. Bei dieser Technologie ist es auch möglich, der Linse selbst noch eine Struktur, also z. B. ein Phasengitter 8.2 aufzuprägen.

Von besonderer Bedeutung ist die möglichst einfache Verbindung des Halbleitersubstrats 6 im Bereich des optoelekronischen Sensors mit dem optisch wirkenden, strukturierten Träger 7. Durch die Rückseitenätzung des Halbleitersubstrats 6 in den aktiven Bereichen der Fotoelemente 2.1 und 2.2 und der Leuchtdiode 1 können alle elektrisch aktiven Bereiche an die Oberfläche des Halbleitersubstrats 6 gelegt werden. Damit können zwei polierte, ebene Fläche wie Silizium und Glas von Halbleitersubstrat 6 und Träger 7 an der Grenzschicht miteinander verbunden werden. Hierzu können Verfahren zum thermischen Bonden oder anodischen Bonden benutzt werden.

Ein weiterer Vorteil des Verbindens des Trägers 7 mit dem Halbleitersubstrat 6 ohne geometrischen Abstand ist, dass mögliches Streulicht sich nicht durch Reflexionen in einem Kanal zwischen Halbleitersubstrat 6 Träger 7 ausbreiten kann.

Wird der Sensor im Mehrfachnutzen auf Waferebene gefertigt, so dient der Träger 7 als Schutz beim späteren Vereinzeln der Sensoren. Ebenso sind die freigeätzten Bereich gegenüber Verunreinigungen geschützt.

Der Träger 7 kann auf der dem Massstab zugewandten Seite mit einer der Wellenlänge angepassten Entspiegelungsschicht versehen werden.
Der Träger 7 kann insbesondere aus dem Material Pyrex bestehen, welches denselben Längenausdehnungskoeffizient wie Silizium aufweist. Dies vermindert Spannungen und erhöht die mechanische Stabilität im Silizium und vermeidet damit Versetzungslinien im Silizium, die zu elektrischen Störstellen führen können.

Das Messsystem, bei dem der erfindungsgemässe Sensor benutzt wird, kann sowohl ein eindimensionales Messsystem, wie Längen- und Winkelmesssysteme, als auch ein zweidimensionales Messsystem sein, wie ein Kreuzgittermesssystem, das als Massstab ein Kreuzlinien- oder Schachbrettgitter aufweist. Das dafür erforderliche Abtastsystem weist entweder zwei erfindungsgemässe, vorteilhaft orthogonal zueinander ausgerichtete Sensoren auf. Alternativ können auch in einen Sensor zwei Gruppen von Fotoelementen mit eindimensionaler Strukturierung integriert werden, deren Ausrichtung den Messrichtungen entsprechen oder die orthogonal zueinander stehen. Das Sendegitter wird dann als zweidimensionales Gitter, beispielsweise Kreuzlinien- oder Schachbrettgitter, ausgestaltet und ist dadurch nur einfach erforderlich.

Um einen kompakteren Aufbau des gesamten Sensors zu erreichen können erfindungsgemäss die weiteren elektronischen Schaltungen 12.1 und 12.2 auch in einem separaten Halbleitersubstrat integriert werden, das räumlich über dem Halbleitersubstrat 6 mit den optoelektronischen Baugruppen angeordnet wird. Da die elektrischen Kontakte erfindungsgemäss bereits ausschliesslich auf der Oberseite des Halbleitersubstrats mit den optoelektronischen Baugruppen angeordnet sind, ist eine Kontaktierung mit dem darüber angeordneten Halbleitersubstrat in Chip on Chip Technologie sehr einfach möglich. Dadurch können die Längen der Verbindungsleitungen zwischen den optoelektronischen und den elektronischen Baugruppen wesentlich verkürzt werden, was zu einer verbesserten Störunempfindlichkeit führt und eine schnellere Signalverarbeitung aufgrund einer höheren Taktrate ermöglicht.

Für den Fachmann ist es offensichtlich, dass die anhand unterschiedlicher Ausführungsbeispiele beschriebenen Merkmale des erfindungsgemässen Sensors beliebig miteinander kombiniert werden können.

Bei dem Verfahren zur Herstellung des erfindungsgemässen Sensors wird in einem ersten Schritt auf dem Silizium-Halbleitersubstrat 6 der benötigten Qualität eine erste Oxidschicht SiO₂ 11.4 nach dem SIMOX-Verfahren in das Halbleitersubstrat 6 eingebracht. Die dabei benutzten Prozessschritte sind aus dem Stand der Technik zu Herstellungsverfahren in der Halbleitertechnik bekannt. Danach wird eine Schicht Silizium 11.3 auf der vom Massstab 10 abgewandten Seite des Halbleitersubstrats 6 in der gewünschten Dicke epitaktisch aufgewachsen.

In einem zweiten Schritt werden die Fotodioden 2.1 und 2.2 durch entsprechende Dotierung der Bereiche, in denen die Fotodetektoren angeordnet sein sollen, erzeugt. In diesem Schritt kann auch die Erzeugung der weiteren Baugruppen wie Verstärker 12.1 und Interpolator 12.2 erfolgen, wenn sie auf dem gleichen Halbleitersubstrat 6 vorgesehen sind.

In einem dritten Schritt werden Leiterbahnen 3.1 und Kontaktierungen 3.2, 12.3 ebenso wie metallische Beschichtungen der Rückseiten der Fotodioden 2.1 aufgebracht. Die erfolgt durch Aufbringen einer Metallisierungsschicht aus Aluminium-Titanoxid, die in bekannten fotochemischen Prozessen entsprechend strukturiert wird.

Im nächsten Schritt erfolgt das Freiätzen der Membranen der Fotodioden 2.1 und 2.2 und das Durchätzen der Öffnungen in Nass- oder Plasmaätzprozessen. Für das Nassätzen wird beispielsweise KOH benutzt und als Ätzstop wird die unter der Oberfläche liegende Siliziumoxidschicht 11.4 benutzt. Das Plasmaätzen erfolgt mit den Ätzgasen CHF₃ und SF₆. Als Ätzstop wird auch hier die Siliziumoxidschicht 11.4 benutzt. Um den Ätzprozess zu überwachen werden die im Ätzgas enthaltenen Komponenten im Licht der Plasmaentladung überwacht - ähnlich wie bei einer Gaschromatographie.

Im nächsten Schritt wird das Träger 7 zum Anbau an das Halbleitersubstrat 6 vorbereitet. Dabei werden die gewünschten Phasen- und/oder Amplitudenteilungen 8.1, 8.2, 8.3 auf den Träger 7 aufgebracht.

Weiterhin besteht die Möglichkeit eine Linse in den Träger 7 zu integrieren, die das Licht der Leuchtdiode 1 kollimiert. Dafür wird in einem PMMA-Resist eine Vorlage für die Linse mittels Elektronenstrahllithographie geformt. Die Dosis während des Belichtens mit Elektronen wird dabei so verändert, dass sich nach dem Entwicklungsprozess die Form einer optischen Linse ergibt. Diese wird, beispielsweise mittels Plasmaätzprozesse, ins Material des Trägers 7 übertragen. Auf diese Art können auch die auf dem Träger 7 vorgesehenen Gitterstrukturen 8.1, 8.2 8.3 erzeugt werden.

Anschliessend wird der Träger 7 mit dem Halbleitersubstrat 6 mittels Bondtechniken, z.B. anodisches oder thermisches Bonden, verbunden.

Im nächsten Schritt wird die Leuchtdiode 1, gegebenenfalls in einem Gehäuse aus Halbleitermaterial mit einem Schild aus Keramik, mit den Kontaktstellen 3.2 elektrisch leitend verbunden.

Falls die weiteren Baugruppen wie Verstärker 12.1 und Interpolator 12.2 nicht neben den optoelektronischen Baugruppen 1, 2.1, 2.2 usw. realisiert werden, kann anschliessend ein zusätzlichen Halbleitersubstrat, in dem die zusätzlichen Baugruppen realisiert sind, von oben mit dem Halbleitersubstrat 6 verbunden werden. Diese Verbindung kann in Chip on Chip Technik ausgeführt werden, so dass die beiden Halbleitersubstrate elektrisch leitend miteinander verbunden werden.

## Patentansprüche

1. Integrierter optoelektronischer Sensor zur Abtastung eines Massstabs (10), der eine Teilung (9) trägt, wobei der Sensor aus einem Halbleitersubstrat (6) besteht,
- welches auf der dem Massstab (10) abgewandten Seite mehrere Fotodetektoren (2.1, 2.2) aufweist, wobei das Halbleitersubstrat (6) im Bereich der Fotodetektoren (2.1, 2.2) zumindest partiell entfernt ist,
- welches auf der dem Massstab (10) abgewandten Seite eine Lichtquelle (1) aufweist, in deren Bereich Halbleiterschicht (11.3), Sperrschicht (11.4) sowie Halbleitersubstrat (6) entfernt sind und
- welches auf der dem Massstab (10) zugewandten Seite mit einem Trägerkörper (7) verbunden ist und der Trägerkörper (7) mindestens eine Teilung (8.1, 8.2, 8.3) aufweist.

2. Sensor nach Anspruch 1, bei dem die Fotodetektoren (2.1, 2.2) in einer Halbleiterschicht (11.3) realisiert sind, die durch eine Sperrschicht (11.4) vom übrigen Halbleitersubstrat (6) isoliert ist.

3. Sensor nach Anspruch 1 oder 2, bei dem die Lichtquelle (1) symmetrisch zu den Fotodetektoren (2.1, 2.2) angeordnet ist.

4. Sensor nach einem der Ansprüche 1 bis 3, bei dem das Halbleitersubstrat (6) aus Silizium, die Sperrschicht (11.4) aus Siliziumoxid SiO₂ oder einem zusätzlichen pn-Übergang realisiert wird und die Halbleiterschicht (11.3) wieder aus Silizium besteht, welches epitaktisch aufgetragen wurde.

5. Sensor nach einem der Ansprüche 1 bis 4, wobei die Lichtquelle (1) divergent ist.

6. Sensor nach einem der Ansprüche 1 bis 5, wobei die Lichtquelle (1) durch eine Leuchtdiode mit einer Linse (1.1) realisiert wird.

7. Sensor nach einem der Ansprüche 1 bis 5, wobei die Lichtquelle (1) durch eine Leuchtdiode realisiert wird und im Träger (7) eine Linse integriert ist.

8. Sensor nach einem der Ansprüche 6 oder 7, wobei die Leuchtdiode (1) mit elektrischen Kontaktflächen (3.2) verbunden ist, die auf der vom Massstab (10) abgewandten Seite des Halbleitersubstrats (6) angeordnet sind, und bevorzugt in Richtung des Massstabs (10) strahlt.

9. Sensor nach einem der Ansprüche 6 oder 7, wobei die Leuchtdiode (1) mit elektrischen Kontaktflächen eines zweiten Halbleitersubstrats verbunden ist, das auf der vom Massstab (10) abgewandten Seite des ersten Halbleitersubstrats (6) mit dem ersten Halbleitersubstrat (6) verbunden ist und die Leuchtdiode (1) bevorzugt in Richtung des Massstabs (10) strahlt.

10. Sensor nach einem der Ansprüche 6 bis 9, wobei die Leuchtdiode (1) in einem Gehäuse oder auf einem Trägerkörper angeordnet ist, welches den gleichen Temperaturausdehnungskoeffizienten wie die Leuchtdiode (1) aufweist.

11. Sensor nach Anspruch 10, bei dem das Gehäuse oder der Trägerkörper der Leuchtdiode (1) aus Silizium oder Gallium-Arsenid bestehen.

12. Sensor nach Anspruch 10 oder 11, bei dem das Gehäuse oder der Trägerkörper der Leuchtdiode (1) einen Keramikträgerkörper beinhalten.

13. Sensor nach einem der Ansprüche 1 bis 12, wobei über der vom Massstab (10) abgewandten Seite des Halbleitersubstrats (6) eine Passivierungsschicht (11.1, 11.2) aus Siliziumoxid und/oder Siliziumnitrit vorgesehen ist.

14. Sensor nach einem der Ansprüche 1 bis 13, bei dem das Halbleitersubstrat (6) auf der dem Massstab (10) abgewandten Seite mindestens eine elektronische Schaltung (12.1, 12.2) trägt, die in der Halbleiterschicht (11.3) realisiert ist.

15. Sensor nach einem der Ansprüche 1 bis 14, wobei auf der vom Massstab (10) abgewandten Seite der Fotodetektoren (2.1, 2.2) eine für die Strahlung der Lichtquelle (1) reflektierende Schicht vorgesehen ist.

16. Sensor nach einem der Ansprüche 1 bis 15, bei dem die Begrenzungsflächen des Halbleitersubstrats (6) im Bereich der Fotodioden (2.1, 2.2) eine Beschichtung aufweisen, die das von der Leuchtdiode (1) emittierte Licht reflektiert.

17. Sensor nach einem der Ansprüche 1 bis 16, bei dem die Sperrschicht (11.4) im Bereich der Fotodioden (2.1, 2.2), wo das von der Leuchtdiode (1) emittierte Licht auftrifft, entspiegelt ist.

18. Sensor nach einem der Ansprüche 1 bis 17, bei dem der Träger (7) einen ähnlichen Temperaturausdehnungskoeffizienten wie das Halbleitersubstrat (6) aufweist.

19. Sensor nach Anspruch 18, wobei der Träger (7) aus Pyrex besteht.

20. Sensor nach einem der Ansprüche 1 bis 19, bei dem elektrische Leitungen (3.1) und Kontaktierungen (3.2, 12.3) auf der vom Massstab (10) abgewandten Seite des Halbleitersubstrats (6) oder auf der Sperrschicht (11.4) oder auf der Halbleiterschicht (11.3) angeordnet sind.

21. Sensor nach einem der Ansprüche 1 bis 20, wobei in den Träger (7) mindestens eine Linse integriert ist,

22. Sensor nach einem der Ansprüche 1 bis 21, wobei der Träger (7) nur auf der dem Massstab (10) zugewandten Seite oder nur auf der dem Massstab (10) abgewandten Seite oder auf beiden Seiten eine Teilung (8.1, 8.2, 8.3) aufweist.

23. Sensor nach einem der Ansprüche 1 bis 22, wobei als Teilung (8.1, 8.2, 8.3) ein Amplitudengitter und/oder ein Phasengitter verwendet wird.

24. Messsystem, welches einen Sensor nach einem der vorhergehenden Ansprüchen und einen Massstab (10) mit einer Teilung (9) aufweist.

25. Verfahren zur Herstellung eines integrierten optoelektronischen Sensors zur Abtastung eines Massstabs nach einem der vorhergehenden Ansprüche, bei dem in ein Halbleitersubstrat (6) eine Sperrschicht (11.4) eingebracht wird, danach auf der Seite des Halbleitersubstrats (6), auf der die Sperrschicht (11.4) eingebracht wurde, in einem Epitaxieverfahren Halbleitermaterial aufgewachsen wird, dann PN-Übergänge für Fotodioden (2.1, 2.2) in die Epitaxie-Schicht (11.3) des Halbleitersubstrats (6) eindiffundiert werden, anschliessend auf der gleichen Seite des Halbleitersubstrats (6) Kontaktierungen (3.1, 3.2, 12.3), Leiterbahnen und Metallisierungsschichten der Fotodetektoren (2.1, 2.2) auf der Oberfläche der Epitaxieschicht (11.3) in einem Metallisierungsschritt aufgebracht werden, anschliessend das Halbleitermaterial des Halbleitersubstrats (6) im Bereich der Fotodetektoren (2.1, 2.2) bis zur Sperrschicht (11.4) und im Bereich der Lichtquelle (1) zusätzlich die Sperrschicht (11.4) und die Epitaxieschicht (11.3) weggeätzt wird, dann die Lichtquelle (1) mit dafür vorgesehenen den Kontakten (3.2) elektrisch leitend verbunden wird und der Träger (7), auf den vorher die benötigten Gitter (8.1, 8.2, 8.3) aufgebracht wurden, mit der dem Massstab (10) zugewandten Seite des Halbleitersubstrats (6) verbunden wird.

26. Verfahren nach Anspruch 25, wobei die Sperrschicht (11.4) aus im SIMOX-Verfahren erzeugtem Siliziumoxid SiO₂b oder einem pn-Übergang besteht.

27. Verfahren nach Anspruch 25 oder 26, wobei die Verbindung zwischen Träger (7) und Halbleitersubstrat (6) mittels thermischem oder anodischem Bonden erfolgt.

28. Verfahren nach einem der Ansprüche 25 bis 27, wobei das Halbleitersubstrat (6) aus Silizium besteht.

29. Verfahren nach einem der Ansprüche 25 bis 28, wobei zum Ätzen ein Nassätz- oder ein Plasmaätzprozess benutzt wird.

30. Verfahren nach einem der Ansprüche 25 bis 29, wobei in den Träger (7) zusätzlich mindestens eine Linse integriert wird.

31. Verfahren nach Anspruch 30, wobei zunächst in einem PMMA-Resist eine Linse mittels Elektronenstrahl-Lithographie erzeugt wird, diese Linse auf den Träger (7) aufgebracht wird und durch Plasmaätzprozess in das Material des Trägers (7) übertragen wird.

32. Verfahren nach einem der Ansprüche 25 bis 31, wobei beim Dotierungsprozess für die pn-Übergänge der Fotodetektoren (2.1, 2.2) gleichzeitig die weiteren Baugruppen (12.1, 12.2) erzeugt werden.

## Claims

1. Integrated optoelectronic sensor for scanning a scale (10), which bears a graduation (9), wherein the sensor consists of a semiconductor substrate (6),
• which has several photodetectors (2.1, 2.2) on the side remote from the scale (10), wherein the semiconductor substrate (6) is at least partially removed in the region of the photodetectors (2.1, 2.2),
• which on the side remote from the scale (10) has a light source (1), in the region of which the semiconductor layer (11.3), barrier layer (11.4) and also semiconductor substrate (6) are removed, and
• which on the side facing the scale (10) is connected to a support body (7) and the support body (7) has at least one graduation (8.1, 8.2, 8.3).

2. Sensor according to claim 1, in which the photodetectors (2.1, 2.2) are formed in a semiconductor layer (11.3), which is insulated from the remaining semiconductor substrate (6) by a barrier layer (11.4).

3. Sensor according to claim 1 or 2, in which the light source (1) is arranged symmetrically to the photodetectors (2.1, 2.2).

4. Sensor according to one of claims 1 to 3, in which the semiconductor substrate (6) is formed from silicon, the barrier layer (11.4) is formed from silicon oxide SiO₂ or an additional pn-junction and the semiconductor layer (11.3) is again formed from silicon, which was applied epitaxially.

5. Sensor according to one of claims 1 to 4, wherein the light source (1) is divergent.

6. Sensor according to one of claims 1 to 5, wherein the light source (1) is formed by a light-emitting diode with a lens (1.1).

7. Sensor according to one of claims 1 to 5, wherein the light source (1) is formed by a light-emitting diode and a lens is integrated in the support (7).

8. Sensor according to one of claims 6 or 7, wherein the light-emitting diode (1) is connected to electrical contact surfaces (3.2), which are arranged on the side of the semiconductor substrate (6) remote from the scale (10), and preferably radiates in the direction of the scale (10).

9. Sensor according to one of claims 6 or 7, wherein the light-emitting diode (1) is connected to electrical contact surfaces of a second semiconductor substrate, which is connected to the first semiconductor substrate (6) on the side of the first semiconductor substrate (6) remote from the scale (10), and the light-emitting diode (1) preferably radiates in the direction of the scale (10).

10. Sensor according to one of claims 6 to 9, wherein the light-emitting diode (1) is arranged in a housing or on a support body, which has the same coefficient of thermal expansion as the light-emitting diode (1).

11. Sensor according to claim 10, in which the housing or the support body of the light-emitting diode (1) is made of silicon or gallium arsenide.

12. Sensor according to claim 10 or 11, in which the housing or the support body of the light-emitting diode (1) contains a ceramic support body.

13. Sensor according to one of claims 1 to 12, wherein a passivation layer (11.1, 11.2) of silicon oxide and/or silicon nitrite is provided over the side of the semiconductor substrate (6) remote from the scale (10).

14. Sensor according to one of claims 1 to 13, in which on the side remote from the scale (10) the semiconductor substrate (6) carries at least one electronic circuit (12.1, 12.2), which is formed in the semiconductor layer (11.3).

15. Sensor according to one of claims 1 to 14, wherein a reflective layer for the radiation of the light source (1) is provided on the side of the photodetectors (2.1, 2.2) remote from the scale (10).

16. Sensor according to one of claims 1 to 15, in which in the region of the photodiodes (2.1, 2.2) the boundary surfaces of the semiconductor substrate (6) have a coating, which reflects the light emitted by the light-emitting diode (1).

17. Sensor according to one of claims 1 to 16, in which the barrier layer (11.4) is antireflection-coated in the region of the photodiodes (2.1, 2.2) where the light emitted by the light-emitting diode (1) strikes.

18. Sensor according to one of claims 1 to 17, in which the support (7) has a similar coefficient of thermal expansion to the semiconductor substrate (6).

19. Sensor according to claim 18, wherein the support (7) is made of Pyrex.

20. Sensor according to one of claims 1 to 19, in which electric leads (3.1) and contacts (3.2, 12.3) are arranged on the side of the semiconductor substrate (6) remote from the scale or on the barrier layer (11.4) or on the semiconductor layer (11.3).

21. Sensor according to one of claims 1 to 20, wherein at least one lens is integrated into the support (7).

22. Sensor according to one of claims 1 to 21, wherein the support has a graduation (8.1, 8.2, 8.3) only on the side facing the scale (10) or only on the side remote from the scale (10) or on both sides.

23. Sensor according to one of claims 1 to 22, wherein an amplitude grating and/or a phase grating is used as graduation (8.1, 8.2, 8.3).

24. Measuring system, which has a sensor according to one of the preceding claims and a scale (10) with a graduation (9).

25. Method for producing an integrated optoelectronic sensor for scanning a scale according to one of the preceding claims, in which a barrier layer (11.4) is incorporated into a semiconductor substrate (6), then semiconductor material is grown in an epitaxial process on the side of the semiconductor substrate (6), on which the barrier layer (11, 3) has been incorporated, pn-junctions for photodiodes (2.1, 2.2) are then diffused into the epitaxial layer (11.3) of the semiconductor substrate (6), on the same side of the semiconductor substrate (6) contacts (3.1, 3.2, 12.3), conductor tracks and metallisation layers of the photodetectors (2.1, 2.2) are then applied to the surface of the epitaxial layer (11.3) in a metallisation step, the semiconductor material of the semiconductor substrate (6) is then etched away in the region of the photodetectors (2.1, 2.2) as far as the barrier layer (11.4) and in region of the light source (1) the barrier layer (11.4) and the epitaxial layer (11.3) are additionally etched away, the light source (1) is then connected electrically conductively to contacts (3.2) provided for this and the support (7), to which the required gratings (8.1, 8.2, 8.3) were previously applied, is connected to the semiconductor substrate (6) on the side of the semiconductor substrate (6) facing the scale (10).

26. Method according to claim 25, wherein the barrier layer (11.4) is made of silicon oxide SiO₂b generated in the SIMOX process or consists of a pn-junction.

27. Method according to claim 25 or 26, wherein the connection between the support (7) and the semiconductor substrate (6) is made by means of thermal or anodic bonding.

28. Method according to one of claims 25 to 27, wherein the semiconductor substrate (6) is made of silicon.

29. Method according to one of claims 25 to 28, wherein a wet etching or plasma etching process is used for etching.

30. Method according to one of claims 25 to 29, wherein at least one lens is additionally integrated into the support (7).

31. Method according to claim 30, wherein a lens is firstly generated in a PMMA resist by means of electron beam lithography, this lens is applied to the support (7) and is transferred into the material of the support (7) by the plasma etching process.

32. Method according to one of claims 25 to 31, wherein the further assemblies (12.1, 12.2) are generated simultaneously in the doping process for the pn-junctions of the photodetectors (2.1, 2.2).

## Revendications

1. Capteur électronique intégré pour explorer une règle de mesure (10) portant une division (9), le capteur étant constitué d'un substrat de semi-conducteur (6), dans lequel :
- sur son côté éloigné de la règle de mesure (10) le substrat (6) présente plusieurs photodétecteurs (2.1, 2.2) et dans la zone de ces photodétecteurs, le substrat est retiré, au moins en partie,
- sur son côté éloigné de la règle de mesure (10) le substrat (6) présente une source de lumière (1) et dans la zone de cette source la couche semi-conductrice (11.3), la couche diélectrique (11.4) ainsi que le substrat de semi-conducteur (6) sont retirés,
- sur son côté éloigné de la règle de mesure 10 (1), le substrat (6) est relié à un corps porteur (7) qui porte au moins une division (8.1, 8.2, 8.3).

2. Capteur selon la revendication 1, dans lequel les photodétecteurs (2.1, 2.2) sont réalisés dans une couche semi-conductrice (11.3) qui est isolée du reste du substrat (6) par une couche diélectrique (11.4).

3. Capteur selon la revendication 1 ou 2, dans lequel la source de lumière (1) est disposée symétriquement par rapport aux photodétecteurs.

4. Capteur selon une des revendications 1 à 3, dans lequel le substrat (6) est en silicium, la couche diélectrique (11.4) en oxyde de silicium SiO₂ ou en une transition pn supplémentaire, et la couche semi-conductrice (11.3) est à nouveau en silicium qui a été déposé par voie épitaxiale.

5. Capteur selon une des revendications 1 à 4, dans lequel la source de lumière (1) est divergente.

6. Capteur selon une des revendications 1 à 5, dans lequel la source de lumière (1) est constituée par une diode électroluminescente équipée d'une lentille (1.1).

7. Capteur selon une des revendications 1 à 5, dans lequel la source de lumière (1) est une diode électroluminescente et une lentille est intégrée au support (7).

8. Capteur selon la revendication 6 ou 7, dans lequel la diode électroluminescente (1) est reliée à des portées de contact (3.2) électriques disposées sur le côté du substrat de semi-conducteur (6) éloigné de la règle de mesure (10), et elle rayonne de préférence en direction de cette règle.

9. Capteur selon la revendication 6 ou 7, dans lequel la diode électroluminescente (1) est reliée à des portées de contact d'un second substrat de semi-conducteur qui, sur la face du premier substrat éloignée de la règle de mesure (10) est relié à celui-ci, la diode (1) rayonnant de préférence en direction de la règle de mesure (10).

10. Capteur selon une des revendications 6 à 9, dans lequel la diode électroluminescente (1) est disposée dans un boîtier ou sur un corps porteur qui présente le même coefficient de dilatation thermique que la diode (1).

11. Capteur selon la revendication 10, dans lequel le boîtier ou le corps porteur de la diode (1) est en silicium ou en arseniure de gallium.

12. Capteur selon la revendication 10 ou 11, dans lequel le boîtier ou le corps porteur de la diode (1) contient un corps porteur en céramique.

13. Capteur selon une des revendications 1 à 12, dans lequel il est prévu, sur le côté du substrat de semi-conducteur (6) éloigné de la règle de mesure, une couche de passivation (11.1, 11.2) en oxyde et/ou en nitrure de silicium

14. Capteur selon une des revendications 1 à 13, dans lequel le substrat de semi-conducteur (6) porte, sur son côté éloigné de la règle de mesure (10) au moins un circuit électronique (12.1, 12.2) réalisé dans la couche semi-conductrice (11.3).

15. Capteur selon une des revendications 1 à 14, dans lequel sur le côté des photodétecteurs (2.1, 2.2) éloigné de la règle de mesure est prévue une couche réfléchissant le rayonnement de la source de lumière (1).

16. Capteur selon une des revendications 1 à 15, dans lequel les surfaces délimitant le substrat de semi-conducteur (6) dans la zone des photodiodes (2.1, 2.2) portent un revêtement qui réfléchit la lumière émise par la diode électroluminescente (1).

17. Capteur selon une des revendications 1 à 16, dans lequel la couche diélectrique (11.4) est traitée antireflet dans la zone des photodiodes (2.1, 2.2) qui est frappée par la lumière émise par la diode électroluminescente (1).

18. Capteur selon une des revendications 1 à 17, dans lequel le support (7) présente le même coefficient de dilatation thermique que le substrat de semi-conducteur (6).

19. Capteur selon la revendication 18, dans lequel le support (7) est en pyrex.

20. Capteur selon une des revendications 1 à 19, dans lequel des conducteurs électriques (3.1) et des contacts (3.2, 12.3) sont disposés sur le côté du substrat de semi-conducteur (6) éloigné de la règle de mesure (10), ou sur la couche diélectrique (11.4) ou sur la couche semi-conductrice (11.3).

21. Capteur selon une des revendications 1 à 20, dans lequel au support (7) est intégré au moins une lentille.

22. Capteur selon une des revendications 1 à 21, dans lequel le support (7) présente une division (8.1, 8.2, 8.3) seulement sur son côté en regard de la règle de mesure (10) ou seulement sur son côté éloigné de la règle de mesure (10 ou sur ses deux côtés.

23. Capteur selon une des revendications 1 à 22, dans lequel est utilisée comme division (8.1, 8.2, 8.3) une grille d'amplitude et/ou une grille de phase.

24. Système de mesure qui présente un capteur selon une des revendications précédentes ainsi qu'une règle de mesure (10) portant une division (9).

25. Procédé de fabrication d'un capteur électronique intégré pour explorer une règle de mesure selon une des revendications précédentes, présentant les étapes successives suivantes :
- une couche diélectrique (11.4) est introduite dans un substrat de semi-conducteur (6),
- sur le côté de ce substrat (6) où se trouve la couche diélectrique (11.4) est déposé par un procédé d'épitaxie un matériau semi-conducteur,
- dans la couche d'épitaxie (11.2) du substrat semi-conducteur sont diffusées des jonctions PN pour des photodiodes (2.1, 2.2),
- sur le même côté du substrat de semi-conducteur (6), sont déposées par métallisation sur la surface de la couche d'épitaxie (11.2) des connexions (3.1, 3.2, 12.3), des pistes conductrices et des couches de métallisation des photodétecteurs (2.1, 2.2),
- le matériau du substrat de semi-conducteur (6), dans la zone des photodétecteurs (2.1, 2.2) est décapé jusqu'à la couche diélectrique (11.4) qui elle-même, ainsi que la couche d'épitaxie (11.2) est décapée dans la zone de la source lumineuse (1),
- cette source lumineuse (1) est reliée électriquement aux contacts (3.2) prévus pour cela,
- le corps porteur (7), sur lequel ont été posées préalablement les grilles (8.1, 8.2, 8.3) nécessaires, est relié au côté du substrat de semi-conducteur (6) en regard de la règle de mesure (10).

26. Procédé selon la revendication 25, dans lequel la couche diélectrique (11.4) est constituée d'une jonction PN ou d'un oxyde de silicium Si0₂ produit par le procédé SIMOX.

27. Procédé selon la revendication 25 ou 26, dans lequel la liaison entre le corps porteur (7) et le substrat de semi-conducteur (6) est réalisée par un assemblage thermique ou anodique.

28. Procédé selon une des revendications 25 à 27, dans lequel le substrat de semi-conducteur (6) est en silicium.

29. Procédé selon une des revendications 25 à 28, dans lequel pour le décapage est utilisé un procédé de décapage par voie humide ou par plasma.

30. Procédé selon une des revendications 25 à 29, dans lequel au corps porteur (7) est de plus intégrée au moins une lentille.

31. Procédé selon la revendication 30, dans lequel tout d'abord dans un revêtement PMMA est produite par lithographie à rayon électronique une lentille qui est déposée ensuite sur le corps porteur (7) et introduite dans le matériau de celui-ci par un procédé de décapage au plasma.

32. Procédé selon une des revendications 25 à 31, dans lequel lors du processus de décapage utilisé pour réaliser les connexions PN des photodétecteurs (2.1, 2.2), les autres composants (12.1, 12.2) sont également réalisés.
